# DEMANDE DE BREVET EUROPEEN

(11) **EP 4 665 100 A1**
(43) Date de publication de la demande: **17.12.2025**
(21) Numéro de dépôt: 25178859.2
(22) Date de dépôt: 26.05.2025
(51) Int. Cl.: H05K 7/20

(54) **MODULE DE REFROIDISSEMENT POUR COMPOSANTS D' ÉLECTRONIQUE DE PUISSANCE**

(30) Priorité: 14.06.2024 FR 2406357
(71) Demandeur: Valeo eAutomotive Germany GmbH, 91056 Erlangen (DE)
(72) Inventeur: POUILLY, Aurélien, 95892 CERGY PONTOISE (FR); COIA, Arnaud, 95892 CERGY PONTOISE (FR); JOMBART, Francois, 95892 CERGY PONTOISE (FR); DIALLO, Massourang, 95892 CERGY PONTOISE (FR)
(74) Mandataire: Valeo Powertrain Systems

(57) **Abrégé**

La présente invention concerne un module de refroidissement pour composants d'électronique de puissance, comportant :
- une plaque support,
- des parois latérales (34, 36) aptes à entourer au moins en partie des composants d'électronique de puissance, les parois latérales (34, 36) délimitant une zone de réception des composants d'électronique de puissance sur la plaque support,
- un circuit (6) de liquide caloporteur s'étendant dans les parois latérales (34, 36), depuis une première extrémité (61) du circuit (6) de liquide caloporteur jusqu'à une deuxième extrémité du circuit (6) de liquide caloporteur,
le module de refroidissement étant caractérisé en ce que les parois latérales (34, 36) sont formées d'une enveloppe étanche (5) et d'une structure (4) emboîtée dans l'enveloppe étanche (5), le circuit (6) de liquide caloporteur étant délimité en partie par la structure (4) et en partie par l'enveloppe étanche (5).

## Description

La présente invention se rapporte aux domaines de la mécanique et de la thermodynamique, et concerne plus précisément un module de refroidissement pour des composants d'électronique de puissance, trouvant une application particulière dans le domaine automobile.

Les véhicules électriques ou hybrides intègrent divers dispositifs d'électronique de puissance pour faire fonctionner leurs moteurs électriques, pour charger leurs batteries haute tension et pour alimenter leurs réseaux de bord.

Ces dispositifs d'électronique de puissance comportent des composants qui sont soumis en fonctionnement à des courants élevés, de plusieurs centaines d'ampères, ce qui provoque une augmentation de leur température et est susceptible de les détériorer en l'absence de moyens de refroidissement spécifiques.

Généralement, les bobines d'arrêt ou les bobines des transformateurs de ces dispositifs d'électronique de puissance sont placées, par l'intermédiaire d'une pâte thermique, sur une plaque de refroidissement parcourue par de l'eau glycolée, circulant dans un circuit de liquide caloporteur comportant un échangeur de chaleur. Ces bobines, et d'autres composants d'électronique de puissance, sont par ailleurs protégés dans des carters dédiés à une fonction précise, telle qu'un carter de chargeur ou de convertisseur courant continu - courant continu.

Etant donné les impératifs d'intégration poussant à réduire de plus en plus l'encombrement généré par ces dispositifs d'électronique de puissance, les inventeurs cherchent à regrouper dans un même carter des composants d'un chargeur et d'un convertisseur courant continu - courant continu, en regroupant certains composants nécessitant un refroidissement spécifique, dans une enceinte dont des parois latérales sont refroidies par de l'eau glycolée. De cette manière, le refroidissement de ces composants est plus efficace qu'avec une simple plaque à eau.

Cependant une telle enceinte est préférentiellement réalisée en acier ou en aluminium par moulage, et sa conception est donc soumise aux contraintes de son procédé de fabrication, qui nécessite notamment des rayons de courbure et des angles adaptés au démoulage de l'enceinte. Il est donc difficile de réaliser une enceinte dont les parois latérales, reliées en angle droit, comportent un circuit de refroidissement efficace, c'est-à-dire réalisant un refroidissement homogène des parois latérales sans beaucoup de pertes de charge.

Par ailleurs, afin de refroidir également d'autres composants du chargeur et du convertisseur courant continu-courant continu, ne nécessitant qu'une surface de refroidissement, du fait par exemple qu'ils s'étendent sur un circuit imprimé, des connexions tubulaires pourraient relier un circuit de liquide caloporteur d'une plaque à eau refroidissant ces autres composants, au circuit de refroidissement de l'enceinte. Ces connexions tubulaires ajouteraient néanmoins de l'encombrement et des pertes de charge, ce qui n'est pas souhaitable.

Il existe donc un besoin de créer un module de refroidissement efficace, industrialisable et peu coûteux, pour des composants d'électronique de puissance montant rapidement en température lors de leur fonctionnement, et permettant une intégration dans un carter comportant d'autres composants d'électronique de puissance pouvant nécessiter également des moyens de refroidissement.

La présente invention vise à remédier au moins en partie aux inconvénients précités en fournissant un module de refroidissement peu coûteux à fabriquer, permettant de refroidir latéralement des composants d'électronique de puissance, avec un circuit de liquide caloporteur pouvant être complexe tout en parcourant plusieurs parois latérales du module de refroidissement.

A cette fin, l'invention propose un module de refroidissement pour composants d'électronique de puissance, comportant :
- une plaque support,
- des parois latérales aptes à entourer au moins en partie des composants d'électronique de puissance, les parois latérales délimitant une zone de réception des composants d'électronique de puissance sur la plaque support,
- un circuit de liquide caloporteur s'étendant dans les parois latérales, depuis une première extrémité du circuit de liquide caloporteur jusqu'à une deuxième extrémité du circuit de liquide caloporteur,
le module de refroidissement étant caractérisé en ce que les parois latérales sont formées d'une enveloppe étanche et d'une structure emboîtée dans l'enveloppe étanche, le circuit de liquide caloporteur étant délimité en partie par la structure et en partie par l'enveloppe étanche.

Le module de refroidissement selon l'invention n'est bien sûr pas limité à une intégration dans un chargeur électrique pour véhicule électrique ou hybride, il trouve des applications dans n'importe quel produit électrique nécessitant un refroidissement de tout ou partie de ses composants.

Par ailleurs, la zone de réception est une partie de la plaque support. Cette zone de réception est destinée à recevoir des composants d'électronique de puissance s'échauffant beaucoup, tels que des bobines d'arrêt ou de transformateurs, et les parois latérales sont aptes à les refroidir.

Le circuit de liquide caloporteur étant entièrement formé par l'enveloppe étanche et par la structure, l'invention permet de simplifier un schéma complexe de circuit de liquide caloporteur en une partie du circuit caloporteur réalisable par une structure apte à être moulée ou usinée, et en une autre partie du circuit caloporteur réalisable par une enveloppe étanche apte à être moulée ou usinée. L'enveloppe étanche est de préférence métallique, par exemple en aluminium ou en acier, ce qui permet une bonne conductivité thermique, et la structure est par exemple métallique ou en matière polymère synthétique. La structure est éventuellement réalisée en plusieurs parties assemblées les unes aux autres.

Grâce à l'invention, on permet une réalisation simple d'un module de refroidissement comportant un même circuit de liquide caloporteur parcourant plusieurs parois latérales du module, ce circuit pouvant prendre des formes complexes et donc parcourir une étendue importante des parois latérales avec peu de pertes de charge.

L'enveloppe étanche et la structure prolongent éventuellement le circuit de liquide caloporteur sur la zone de réception. Ainsi, le circuit de liquide caloporteur sur la zone de réception forme une surface de refroidissement destinée à être interposée entre la plaque support et les composants d'électronique de puissance, la surface de refroidissement couvrant par exemple au moins 90% de la zone de réception.

Les composants d'électronique de puissance susceptibles de beaucoup s'échauffer sont donc, dans cette réalisation de l'invention, destinés à être agencés sur une portion de l'enveloppe étanche et de la structure située sur la zone de réception, ce qui permet de les refroidir également sur leurs bases, sans utiliser de plaque froide supplémentaire. La surface de refroidissement correspondante est formée par la surface de l'enveloppe étanche délimitant le circuit caloporteur au-dessus de la zone de réception, entre les parois latérales du module de refroidissement.

Dans un mode de réalisation de l'invention, la structure est formée de blocs de matière comportant des évidements droits débouchant en regard de l'enveloppe étanche ou de la plaque support, les évidements droits s'intersectant les uns les autres de la première à la deuxième extrémité du circuit de liquide caloporteur. Autrement dit dans ce mode de réalisation de l'invention, la partie du circuit de liquide caloporteur formée par la structure, est réalisable uniquement par des perçages, par exemple orthogonalement aux parois des blocs de matière formant la structure, ces blocs de matière étant par exemple parallélépipédiques. En variante, les blocs de matière de la structure ne sont pas parallélépipédiques et les évidements droits sont effectués selon des angles différents de 90° par rapport aux parois des blocs de matière, ces angles étant cependant suffisamment importants pour permettre à une fraise de pratiquer les évidements correspondants.

Selon une caractéristique optionnelle et avantageuse de l'invention, la structure est formée d'une seule pièce usinée. Cela permet une réalisation peu coûteuse. En variante, la structure est formée par injection haute pression, ou en plusieurs morceaux assemblés les uns aux autres par soudage, collage ou vissage.

Dans un mode de réalisation de l'invention, le module de refroidissement comporte au moins une plaque de fermeture rapportée sur l'enveloppe étanche et disposée entre la plaque support et la structure, la plaque de fermeture comportant un premier orifice en regard de la première extrémité du circuit de liquide caloporteur et un deuxième orifice en regard de la deuxième extrémité du circuit de liquide caloporteur.

Cette plaque de fermeture est rapportée de manière étanche sur l'enveloppe étanche, de sorte à enfermer complètement la structure entre l'enveloppe étanche et la plaque de fermeture, le liquide caloporteur ne pouvant passer que par le premier et le deuxième orifice. En variante, cette plaque de fermeture est formée par la structure elle-même. On comprend que le circuit de liquide caloporteur peut ne pas être complètement étanche entre la structure et l'enveloppe étanche, du moment que le liquide caloporteur ne peut pas fuir de l'enveloppe étanche et de la plaque de fermeture ou de la portion de la structure fermant l'enveloppe étanche, autrement que par les premier et deuxième orifices de la plaque de fermeture ou respectivement par les première et deuxième extrémités du circuit de liquide caloporteur.

Dans un mode de réalisation de l'invention, le circuit de liquide caloporteur parcourt trois parois latérales du module de refroidissement, dites parois latérales de refroidissement, le module de refroidissement comportant en outre au moins une paroi latérale de séparation entre composants d'électronique de puissance, formée uniquement par l'enveloppe étanche.

Par exemple, la paroi latérale de séparation est apte à séparer les composants d'électronique de puissance agencés au-dessus de la zone de réception, des autres composants d'électronique de puissance du module de refroidissement, ou bien est apte à séparer entre eux les composants d'électronique de puissance agencés au-dessus de la zone de réception. Ces parois latérales de séparation ont un effet de blindage électromagnétique.

En variante, le module de refroidissement comporte des parois latérales de refroidissement aptes à séparer entre eux des composants d'électronique de puissance agencés au-dessus de la zone de réception, en supplément des parois latérales de refroidissement qui entourent l'ensemble des composants d'électronique de puissance agencés au-dessus de la zone de réception.

Dans ce mode de réalisation de l'invention, l'enveloppe étanche comporte pour chaque paroi latérale de refroidissement, une cloison destinée à être en regard des composants d'électronique de puissance, le circuit de liquide caloporteur s'étendant par exemple sur au moins 90% de la cloison. Cette caractéristique de l'invention permet un refroidissement efficace et homogène des composants d'électronique de puissance présents au-dessus de la zone de réception.

Dans un mode de réalisation de l'invention, la plaque support comporte une entrée de liquide caloporteur et une sortie de liquide caloporteur, une première zone de jonction reliant l'entrée de liquide caloporteur à la première extrémité du circuit de liquide caloporteur et une deuxième zone de jonction reliant la sortie de liquide caloporteur à la deuxième extrémité du circuit de liquide caloporteur.

La première et la deuxième zone de jonction sont par exemple situées au moins en partie du côté opposé aux parois latérales par rapport à la plaque support, celle-ci comportant une première ouverture joignant la première zone de jonction au premier orifice de la plaque de fermeture et une deuxième ouverture joignant la deuxième zone de jonction au deuxième orifice de la plaque de fermeture. Les première et deuxième zones de jonction sont de plus ou en variante, au moins en partie moulées dans la plaque support.

Ainsi les première et deuxièmes zones de jonction refroidissent au moins a minima la plaque support, et donc les composants d'électronique de puissance du module de refroidissement qui ne sont pas situés au-dessus de la zone de réception, sans ajout de connexions tubulaires.

Ce mode de réalisation permet donc de connecter en série le circuit de liquide caloporteur présent dans les parois latérales, et un circuit de refroidissement présent dans la plaque support, de manière peu onéreuse.

Dans ce mode de réalisation, les composants d'électronique de puissance sont par exemple des premiers composants d'électronique de puissance, la zone de réception est une première zone de réception, la plaque support comportant une deuxième zone de réception de deuxièmes composants d'électronique de puissance s'étendant au-delà des parois latérales et de la première zone de réception, la première zone de jonction ou la deuxième zone de jonction étant apte à former une surface de refroidissement des deuxièmes composants d'électronique de puissance en amenant le liquide caloporteur au contact de la deuxième zone de réception des deuxièmes composants d'électronique de puissance. La surface de refroidissement des deuxièmes composants d'électronique de puissance est une deuxième surface de refroidissement lorsque le circuit de liquide caloporteur sur la zone de réception forme également une surface de refroidissement, appelée dans ce cas première surface de refroidissement.

Les premiers composants d'électronique de puissance sont des composants d'électronique de puissance aptes à beaucoup s'échauffer et disposés entre les parois latérales du module de refroidissement. Il s'agit notamment de bobines d'arrêt ou de transformateurs. Les deuxièmes composants d'électronique de puissance sont par exemple des condensateurs ou des transistors. La deuxième surface de refroidissement s'étend par exemple sur au moins 40% de la deuxième zone de réception.

La première zone de jonction ou la deuxième zone de jonction comportent par exemple d'une part un conduit dans la plaque support s'étendant au moins depuis l'entrée ou respectivement la sortie de liquide caloporteur jusqu'à une nervure de la plaque support, délimitant la première surface de refroidissement et/ou la deuxième surface de refroidissement, et d'autre part une plaque de fermeture rapportée sur la nervure.

Lorsque la première zone de jonction est apte à former la surface de refroidissement des deuxièmes composants d'électronique de puissance, la plaque support comporte éventuellement une troisième zone de réception de troisièmes composants d'électronique de puissance s'étendant au-delà des parois latérales et de la première zone de réception, la deuxième zone de jonction étant apte à former une surface de refroidissement des troisièmes composants d'électronique de puissance en amenant le liquide caloporteur au contact de la troisième zone de réception des troisièmes composants d'électronique de puissance. La surface de refroidissement des troisièmes composants d'électronique de puissance est une troisième surface de refroidissement lorsque le circuit de liquide caloporteur sur la zone de réception forme une première surface de refroidissement.

Les troisièmes composants d'électronique de puissance sont par exemple des condensateurs ou des transistors. La troisième surface de refroidissement s'étend par exemple sur au moins 40% de la troisième zone de réception.

L'invention concerne aussi un dispositif d'électronique de puissance d'un véhicule électrique ou hybride, dont au moins une partie des composants sont agencés dans un module de refroidissement selon l'invention. Le dispositif d'électronique de puissance est par exemple apte à assurer une fonction de recharge d'une batterie haute tension du véhicule, et à assurer une fonction de convertisseur courant continu-courant continu. Les premiers composants d'électronique de puissance au-dessus de la première zone de réception sont alors les transformateurs du dispositif d'électronique de puissance selon l'invention, et éventuellement une bobine d'arrêt du dispositif d'électronique de puissance selon l'invention.

D'autres caractéristiques et avantages de l'invention apparaîtront encore au travers de la description qui suit d'une part, et de plusieurs exemples de réalisation donnés à titre indicatif et non limitatif en référence aux dessins schématiques annexés d'autre part, sur lesquels :
[fig 1] représente en perspective un module de refroidissement selon l'invention, dans un mode de réalisation de l'invention, une plaque support du module de refroidissement étant représentée schématiquement seulement,
[fig 2] représente en perspective une plaque de fermeture et une structure du module de refroidissement de la figure 1, le module de refroidissement étant représenté sans la plaque support et sans une enveloppe étanche qui recouvre la structure sur la figure 1,
[fig 3] représente en perspective et en coupe partielle l'enveloppe étanche du module de refroidissement de la figure 1, recouvrant la structure et fermée par la plaque de fermeture,
[fig 4] représente de manière isolée et en perspective la structure du module de refroidissement de la figure 1,
[fig 5] est une autre vue en perspective de la structure du module de refroidissement de la figure 1, montrant au premier plan une face de la structure, opposée à la face de la structure montrée au premier plan de la figure **4****,** et permettant d'illustrer le trajet susceptible d'être suivi par un liquide caloporteur,
[fig 6] est une vue de dessus et en perspective de la plaque support du module de refroidissement de la figure 1, et
[fig 7] est une vue de dessous et en perspective de la plaque support représentée figure 6.

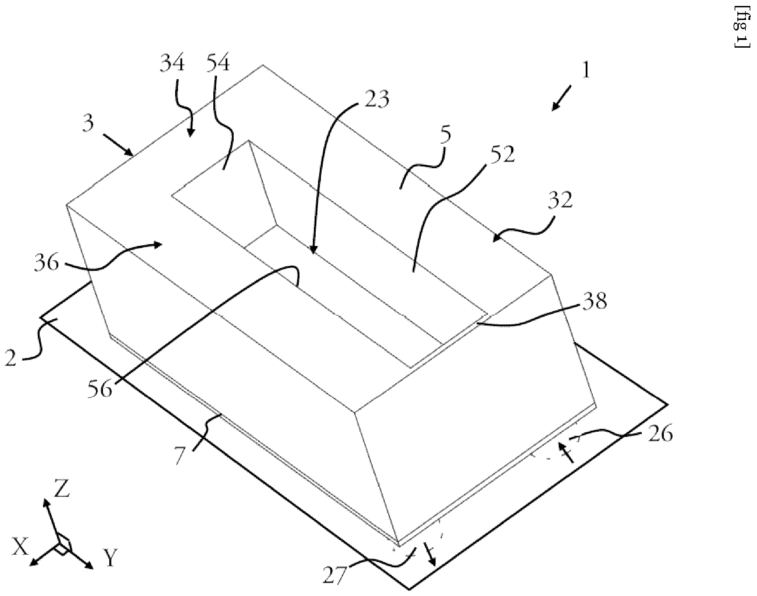

Selon un mode de réalisation de l'invention représenté sur les figures 1 à 7, un module de refroidissement 1 selon l'invention, représenté figure 1, est destiné à faire partie d'un carter d'un dispositif d'électronique de puissance intégrant un chargeur de batterie haute tension de véhicule électrique ou hybride, et un convertisseur courant continu - courant continu. Bien sûr, l'invention est applicable à d'autres types de dispositifs d'électronique de puissance.

Le module de refroidissement 1 comporte pour cela une plaque support 2, formant un fond du carter, et sur laquelle sont destinés à être agencés les composants du dispositif d'électronique de puissance. Plus précisément, les composants du dispositif d'électronique de puissance sont destinés à être agencés sur une face supérieure de la plaque support 2, en regard de l'intérieur du carter. Des connecteurs électriques agencés sur des bords relevés de la plaque support 2, ici non représentés, permettent de relier électriquement le dispositif d'électronique de puissance à une batterie haute tension d'un véhicule, à une prise de recharge du véhicule, et à un réseau de bord du véhicule.

La plaque support 2 est sensiblement rectangulaire et s'étend parallèlement à une direction longitudinale Y suivant la longueur de la plaque support 2, et s'étend parallèlement à une direction transversale X suivant la largeur de la plaque support 2, la direction transversale X étant orthogonale à la direction longitudinale Y.

Une direction verticale Z orthogonale aux directions d'extension principales de la plaque support 2 est dirigée de perpendiculairement à la plaque support 2. Les termes « au-dessus », « au-dessous », « bas », « haut », « supérieur » et « inférieur » dans cette demande se réfèrent, dans cette direction verticale Z, à une orientation « vers le haut », depuis le fond du carter le long des bords relevés. Les termes « transversal » ou « longitudinal » dans cette demande se réfèrent aux directions respectivement transversale X et longitudinale Y.

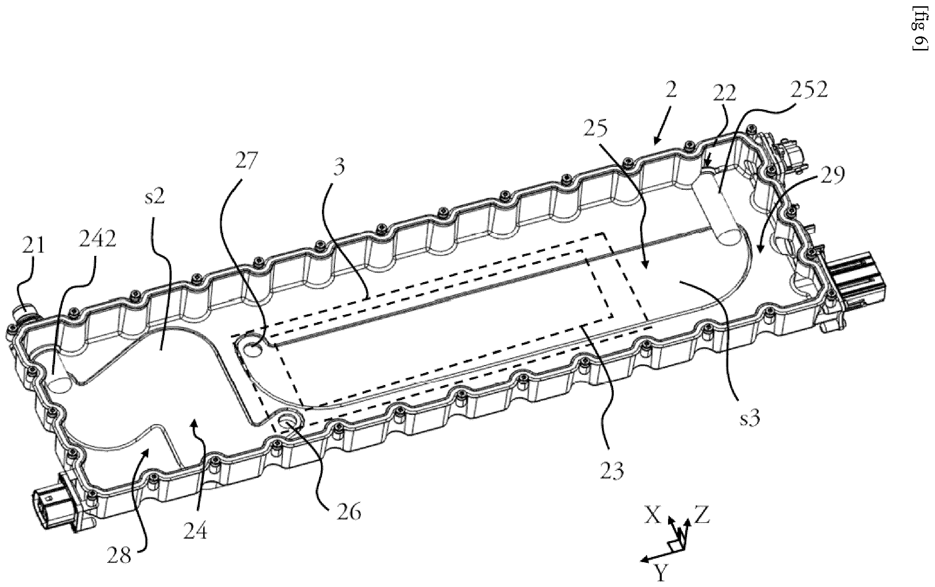

Le module de refroidissement 1 comporte également un ensemble 3 de parois latérales 32, 34, 36, 38 délimitant une enceinte dont l'empreinte sur la face supérieure de la plaque support 2 définit une première zone de réception 23. Cette première zone de réception 23 est destinée à la fixation de premiers composants d'électronique de puissance, susceptibles de s'échauffer beaucoup, tels que les bobines d'arrêt et de transformateurs du dispositif d'électronique de puissance. Cette première zone de réception 23 est représentée en pointillés sur la figure 6 montrant une réalisation de la plaque support 2.

Comme visible sur la figure 6, la plaque support 2 comporte également une deuxième zone de réception 28 de deuxièmes composants du dispositif d'électronique de puissance, et une troisième zone de réception 29 de troisièmes composants du dispositif d'électronique de puissance, situées sur la face supérieure de la plaque support 2. Les deuxièmes et troisièmes composants du dispositif d'électronique de puissance ont un besoin de refroidissement moins important que les premiers composants du dispositif d'électronique de puissance. Il s'agit par exemple de condensateurs et de transistors.

Il est à noter que dans des variantes de réalisation de l'invention, la plaque support ne comporte que la première zone de réception, ou seulement la première zone de réception et l'une parmi la deuxième ou la troisième zone de réception.

Bien sûr les composants d'électronique de puissance évoqués ici ne sont pas forcément directement mis en contact avec la plaque support 2, ils sont par exemple intégrés à un circuit imprimé ou PCB (d'après l'anglais « Printed Circuit Board ») qui est fixé sur la plaque support 2 par l'intermédiaire d'une pâte thermique. La plaque support peut également former des cloisons verticales pour cloisonner les composants d'électronique de puissance entre eux.

Revenant à la figure 1, les parois latérales 32, 34, 36, 38 du module de refroidissement 1 s'étendent principalement dans la direction verticale Z et sont délimitées par une enveloppe étanche 5, rapportée de manière étanche sur une plaque de fermeture 7, elle-même rapportée sur la plaque support 2. La plaque de fermeture 7 s'étend principalement selon les directions longitudinale Y et transversale X, entre les parois latérales 32, 34, 36, 38 du module de refroidissement 1 et la plaque support 2, tout en recouvrant la première zone de réception 23. Tel que cela sera détaillé ci-après, les parois latérales du module de refroidissement 1 comportent des parois latérales de refroidissement 32, 34, 36 et une paroi latérale de séparation 38.

L'enveloppe étanche 5 est de préférence métallique, par exemple en acier ou en aluminium, et est par exemple réalisée par moulage ou par emboutissage. La plaque de fermeture 7 est également de préférence métallique, par exemple en acier ou en aluminium. La matière de l'enveloppe étanche 5 est choisie notamment pour sa bonne conductivité thermique.

Une première ouverture 26 dans la plaque support 2 permet à un liquide caloporteur (représenté par des flèches) d'entrer dans une paroi latérale 32 du module de refroidissement 1, et une deuxième ouverture 27 dans la plaque support 2 permet au liquide caloporteur (représenté par des flèches) de sortir d'une autre paroi latérale 36 du module de refroidissement 1.

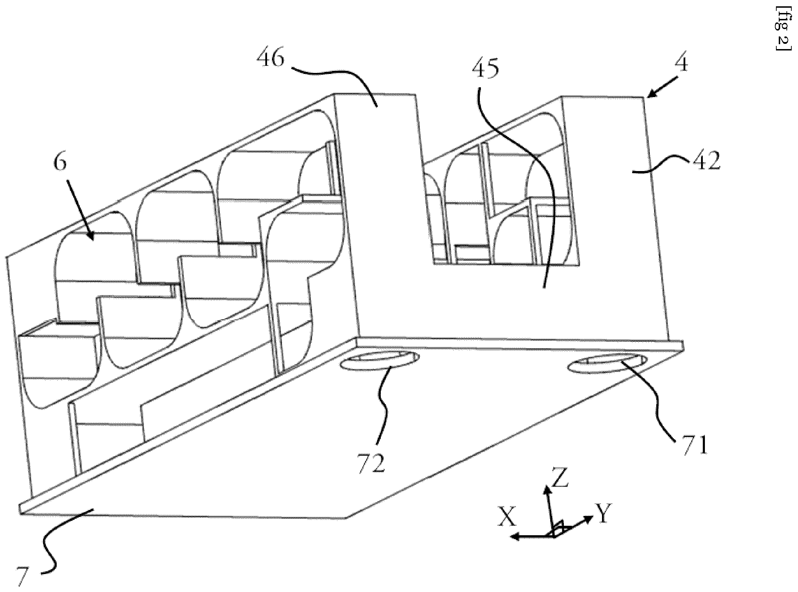

Ces deux parois latérales 32, 36 parallèles entre elles, ainsi qu'une paroi latérale 34 les reliant, forment un U et logent un circuit 6 de liquide caloporteur référencé figure 2. Les trois parois latérales 32, 34, 36 formant ce U sont donc des parois latérales de refroidissement. Le liquide caloporteur est par exemple de l'eau glycolée, ou de l'huile. Ce liquide caloporteur est ainsi destiné à pénétrer dans la paroi latérale 32 par l'intermédiaire de la première ouverture 26, à circuler au sein de cette paroi latérale 32 puis au sein de chacune des parois latérales 34, 36 successivement agencées les unes après les autres, puis à ressortir via la deuxième ouverture 27.

Le circuit 6 de liquide caloporteur est formé d'une part par l'enveloppe étanche 5, et d'autre part par une structure 4 emboîtée dans l'enveloppe étanche 5, la structure 4 comportant des évidements formant des méandres pour le passage du liquide caloporteur. Cette structure 4 est par exemple réalisée en matière polymère moulée, ou en métal usiné ou moulé. Elle peut donc être métallique.

La structure 4 est de préférence insérée en force dans l'enveloppe étanche 5 de sorte à ce que celle-ci ferme complètement les évidements de la structure 4 débouchant sur l'enveloppe étanche 5. Par ailleurs, la structure 4 et l'enveloppe étanche 5 sont rendus solidaires par des moyens appropriés, le cas échéant accompagné de moyens d'étanchéité, pour figer la position de la structure au sein de l'enveloppe étanche. Par exemple, la structure 4 comporte des godrons qui viennent s'insérer en force dans des évidements appropriés formés dans une surface interne de l'enveloppe étanche. En variante, la structure 4 et l'enveloppe étanche 5 comportent des moyens de fixation par vissage, associés à des moyens d'étanchéité tels que des joints d'étanchéité. Dans une autre variante, la structure 4 et l'enveloppe étanche 5 sont fixés l'un à l'autre par des moyens de fixation élastiques tels qu'un bossage sur la structure 4, venant déformer temporairement l'enveloppe étanche 5 pour s'insérer dans un creux de celle-ci. Dans une autre variante, l'enveloppe étanche 5 est soudée à la structure 4, par exemple brasée à la structure 4.

On comprend que le montage à force de la structure 4 au sein de l'enveloppe étanche 5 a pour but de positionner la structure au plus près des parois de l'enveloppe étanche, mais qu'il ne doit pas aboutir nécessairement à un plaquage strict des bords de la structure sur les parois définissant l'enveloppe étanche et qu'un jeu peut être présent à la jonction d'un bord et d'une paroi. Le liquide caloporteur a en effet tendance à suivre le chemin de plus grande section ménagé par les méandres formé par les évidements de la structure 4, plutôt que de chercher à s'insérer par des interstices entre la structure et l'enveloppe étanche.

La plaque de fermeture 7 est rapportée de manière étanche sur l'enveloppe étanche 5, par exemple par brasage, soudure par friction malaxage, collage ou par l'intermédiaire d'un joint d'étanchéité.

Comme visible figure 2, la plaque de fermeture 7 comporte un premier orifice 71 qui est agencé en regard de la première ouverture 26 de la plaque support 2, et un deuxième orifice 72 qui est agencé en regard de la deuxième ouverture 27 de la plaque support 2. Des moyens d'étanchéité sont disposés d'une part entre le premier orifice 71 et la première ouverture 26 et d'autre part entre le deuxième orifice 72 et la deuxième ouverture 27. Ces moyens d'étanchéité sont par exemple des joints d'étanchéité plats ou annulaires, disposés dans des logements formés dans la plaque support 2 autour de la première ouverture 26 et de la deuxième ouverture 27 et visibles figure 6.

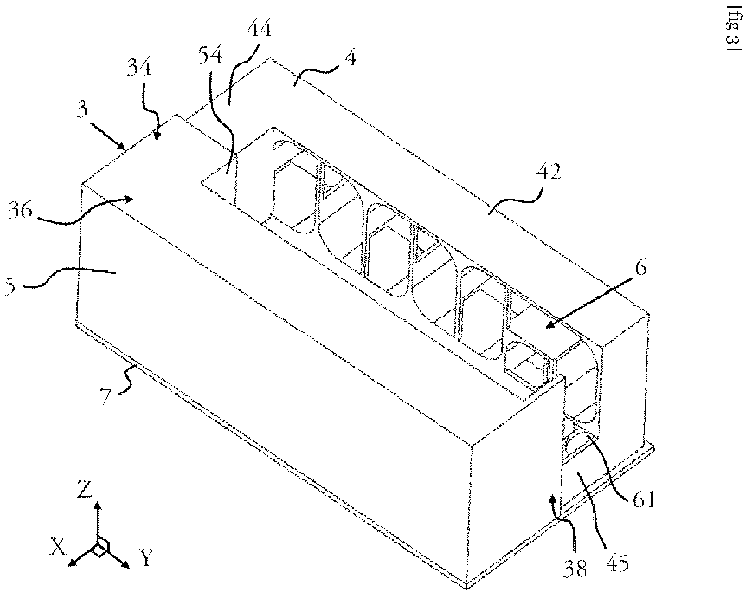

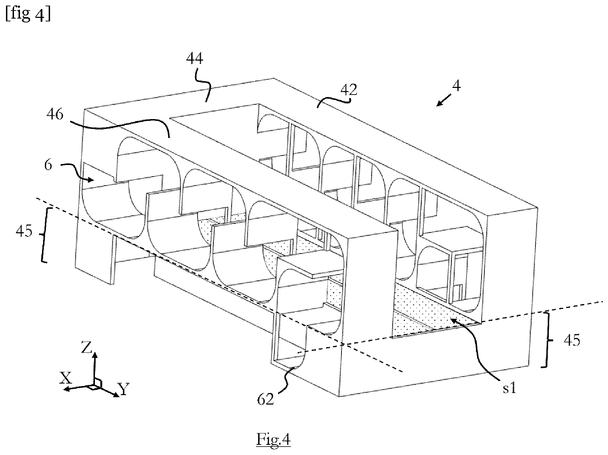

Comme visible figures 2 et 3, la structure 4 comporte trois blocs de matière 42, 44 et 46 et une base 45 qui forme un socle commun aux blocs de matière, ces blocs de matière étant agencés sur les bords de la base de manière à créer une forme en U, avec donc un côté de la base 45 qui n'est recouvert par aucun bloc de matière. L'agencement en U des blocs de matière forme entre eux un logement pour des composants d'électronique de puissance, ce logement étant délimité verticalement par la portion centrale de la base non recouverte par les blocs de matière, cette base 45 étant rendue plus particulièrement visible sur la figure 4 avec une illustration par des traits pointillés d'un plan séparant verticalement la base 45 des blocs de matière 42, 44, 46.

Les blocs de matière 42, 44, 46 sont parallélépipédiques et comportent chacun des évidements agencés de manière continue, c'est-à-dire en débouchant sur l'évidement disposé en aval lorsque l'on considère le sens d'écoulement du liquide de refroidissement. Ces trois blocs de matière s'étendent tous les trois principalement selon la direction verticale Z d'une part et selon l'une des directions longitudinale Y et transversale X d'autre part, avec un bloc de matière central 44 interposé entre deux blocs de matière parallèles 42, 46 pour former une forme en U apte à être insérée dans l'enveloppe étanche 5 pour former respectivement les trois parois latérales 32, 34 et 36 de refroidissement.

La base 45 est dimensionnée pour recouvrir la zone de réception 23 de la plaque support 2, et elle est recouverte d'un côté par la plaque de fermeture 7, au contact direct de la zone de réception de la plaque support, et de l'autre côté par l'enveloppe étanche 5 interposée entre les composants d'électronique de puissance et cette base 45 participant à définir le circuit 6 au sein duquel du fluide de refroidissement circule.

Revenant à la figure 1, l'enveloppe étanche 5 est configurée pour former la paroi latérale de séparation 38 s'étendant principalement selon la direction verticale Z et la direction transversale X, pour relier les deux parois latérales 32, 36 de refroidissement formant les branches du U en fermant celui-ci. Cette paroi latérale de séparation 38 s'étend verticalement depuis la plaque de fermeture 7, sur une hauteur mesurée le long de la direction verticale Z qui est ici égale à la hauteur correspondante des parois latérales 32, 34, 36 de refroidissement. La paroi latérale de séparation 38 ne loge pas de bloc de matière de la structure 4 et est donc moins épaisse que les trois parois latérales 32, 34, 36 de refroidissement, étant uniquement formée par l'enveloppe étanche 5. Cette paroi latérale de séparation 38 est en effet une paroi latérale de séparation permettant de séparer les premiers composants d'électronique de puissance des deuxièmes composants d'électronique de puissance. D'autres parois latérales de séparation sont en variante prévues pour séparer entre elles les bobines destinées à être logées au-dessus de la zone de réception 23. Dans une autre variante, la plaque de fermeture est une paroi latérale de refroidissement.

Les parois latérales de refroidissement 32, 34, 36 sont notamment formées par des cloisons de l'enveloppe étanche 5 qui viennent en recouvrement de la structure 4, notamment pour fermer les évidements de la structure et délimiter le circuit de circulation de fluide de refroidissement. Notamment, on peut distinguer des cloisons internes 52, 54, 56 destinées à être respectivement en regard des composants d'électronique de puissance positionnés dans le logement agencé entre les parois latérales de refroidissement et la base de la structure recouverte de l'enveloppe étanche. Deux des cloisons internes 52, 56, respectivement associées à une paroi latérale 32 36 de refroidissement formant la branche du U, ferment des évidements de la structure 4, dans lesquels circule le liquide caloporteur, tandis qu'une autre 54 des cloisons n'est séparée de tels évidements que d'une fine couche de matière formant une cloison propre à un bloc de matière de la structure. Au niveau des branches du U, la surface d'une cloison 52, 56 au contact d'évidements de la structure 4 correspond à au moins 90% de l'aire d'une face de cette cloison 52, 54, voire à au moins 30% de cette aire. Ainsi les premiers composants d'électronique de puissance peuvent être refroidis de manière efficace du fait d'une surface de refroidissement particulièrement étendue.

Il est à noter que les parois latérales de refroidissement 32, 34, 36 s'étendent en partie basse de la structure 4, jusqu'à la plaque de fermeture 7.

Comme en partie visible sur les figures 3 et 4, la structure 4 comporte un premier évidement en regard du premier orifice 71 de la plaque de fermeture 7, cet évidement formant une première extrémité 61 du circuit 6 de liquide caloporteur, et un dernier évidement en regard du deuxième orifice 72 de la plaque de fermeture 7, ce dernier évidement formant une deuxième extrémité 62 du circuit 6 de liquide caloporteur. La première extrémité 61 et la deuxième extrémité 62 sont chacune situées à une extrémité libre distincte du U formé par les parois latérales 32, 34, 36 de refroidissement.

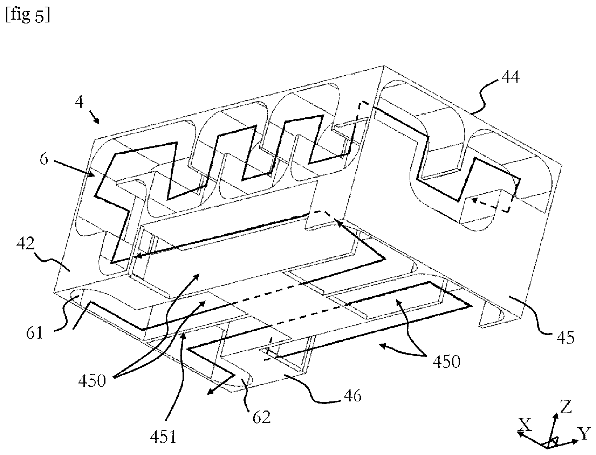

Par ailleurs, comme visible sur la figure 4 et la figure 5, la base 45 de la structure comporte deux évidements longitudinaux 450, formant des tranchées débouchant dans l'enceinte formée par les parois latérales 32, 34, 36, 38 du module de refroidissement 1 et s'étendant longitudinalement de la paroi latérale de séparation 38 à la paroi latérale 34 de refroidissement formant la base du U. Ils sont séparés uniquement par une fine cloison longitudinale 451 de matière destinée d'une part à garder rigide la base 45 de la structure 4, très creusée, et destinée d'autre part à cloisonner une section d'entrée de liquide de refroidissement et une section de sortie de ce liquide. La surface de contact entre ces deux évidements et l'enveloppe étanche 5 forme une première surface de refroidissement s1 disposée orthogonalement à la direction verticale Z et destinée à refroidir les parties inférieures des premiers composants d'électronique de puissance. Cette première surface de refroidissement s1 a été représentée schématiquement sur la figure 4 pour faciliter la compréhension du lecteur, même si l'enveloppe étanche n'est pas ici illustrée. Cette première surface de refroidissement s1, lorsqu'elle existe, recouvre de préférence au moins 90% de la première zone de réception 23, voire au moins 30% de la zone de réception 23. Cette première surface de refroidissement s1 est optionnelle.

La figure 4 montre également que la structure 4 comporte un plan de symétrie vertical et longitudinal. Les évidements dans la structure 4 sont symétriques par rapport à ce plan de symétrie vertical et longitudinal, ce qui permet de mieux visualiser le trajet du circuit 6 de liquide caloporteur partiellement représenté par des flèches sur la figure 5. Les passages du trajet en pointillés représentent des passages masqués par des bouts de structure 4.

Comme visible sur les figures 4 et 5, les évidements dans les blocs de matière parallélépipédiques 42, 44, 46 de la structure 4, et dans la base 45 de la structure 4, également parallélépipédique, sont des évidements droits réalisés orthogonalement aux parois de ces blocs de matière parallélépipédiques ou de cette base 45. Autrement dit, les évidements sont réalisés de telle façon que les parois délimitant ces évidements et permettant une communication d'un évidement à un autre sont des parois orthogonales aux parois des blocs de matière parallélépipédiques 42, 44, 46 et de la base 45. La structure 4 est par exemple formée d'une seule pièce de matière usinée et les évidements droits sont réalisés par des perçages ou par moulage.

Tel qu'évoqué précédemment, les évidements dans les blocs de matière parallélépipédiques 42, 44, 46 de la structure 4 et dans la base 45 de la structure 4 s'intersectent les uns les autres de sorte à créer un passage pour le liquide caloporteur, entre la première extrémité 61 et la deuxième extrémité 62 du circuit 6 de liquide caloporteur.

Dans ce mode de réalisation de l'invention, les évidements dans les blocs de matière parallélépipédiques 42, 44, 46 dessinent des créneaux aussi hauts que larges et occupant la majeure partie de ces blocs de matière. De plus, dans ce mode de réalisation de l'invention, les évidements dans deux des blocs de matière parallélépipédiques 42 et 46 sont traversants, tandis que les évidements dans un autre 44 des blocs de matière parallélépipédiques ne sont pas traversants. En variante de réalisation de l'invention, au moins une partie des évidements de la variante principale de réalisation ne sont pas traversants au lieu d'être traversants et inversement. Dans une autre variante de réalisation de l'invention, les évidements dessinent des sillons longitudinaux ou transversaux, ou des circonvolutions, ou encore des méandres de formes quelconques.

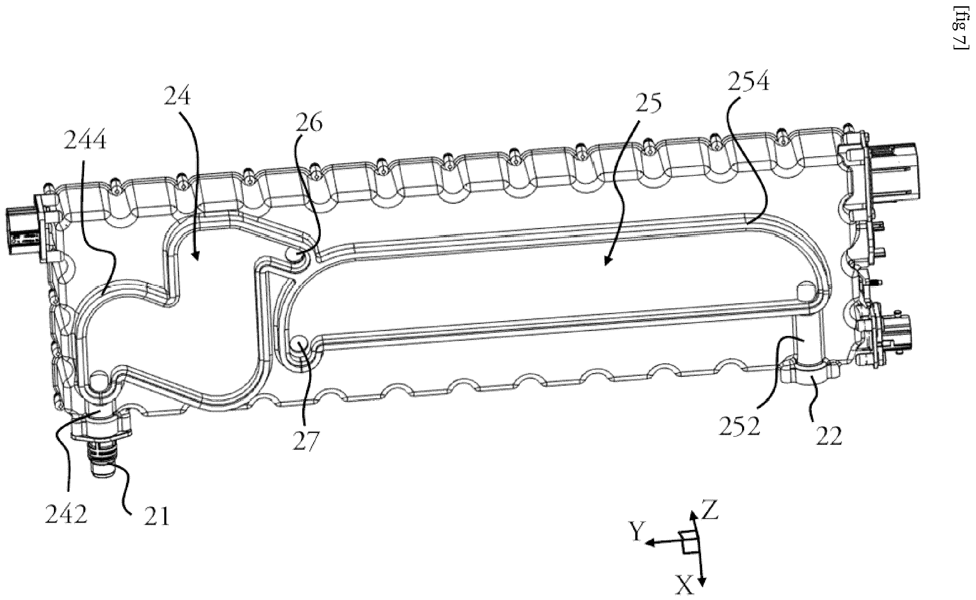

On décrit maintenant plus en détail la plaque support 2 en relation avec les figures 6 et 7. L'empreinte externe de l'ensemble 3 des parois latérales 32, 34, 36, 38 du module de refroidissement 1 est marquée par des pointillés autour de la première zone de réception 23.

La plaque support 2 comporte une entrée 21 de liquide caloporteur et une sortie 22 de liquide caloporteur.

Une première zone de jonction 24 relie l'entrée 21 de liquide caloporteur à la première ouverture 26 dans la plaque support 2, reliée à la première extrémité 61 du circuit 6 de liquide caloporteur par le premier orifice 71 de la plaque de fermeture 7. La première zone de jonction 24 comporte un premier conduit 242 moulé dans la plaque support 2, débouchant d'une part sur l'entrée 21 de liquide caloporteur et d'autre part sur un premier espace délimité par une première nervure 244 (visible figure 7) de la plaque support 2, agencée sur la face inférieure de la plaque support 2, c'est-à-dire du côté opposé aux parois latérales 32, 34, 36 du module de refroidissement 1 par rapport à la plaque support 2. Une première plaque de fermeture, non représentée, ferme de manière étanche ce premier espace en étant fixée sur la première nervure 244, par exemple par brasage ou par soudage par friction malaxage. Dans ce cas la première plaque de fermeture est métallique. Cette première nervure 244 s'étend sous la deuxième zone de réception 28 et délimite donc une deuxième surface de refroidissement s2, destinée à refroidir les deuxièmes composants d'électronique de puissance.

La deuxième surface de refroidissement s2, optionnelle, s'étend par exemple sur au moins 10% de la deuxième zone de réception 28, voire sur au moins 40 à 80% de la deuxième zone de réception 28.

De façon similaire, une deuxième zone de jonction 25 relie la sortie 22 de liquide caloporteur à la deuxième ouverture 27 dans la plaque support 2, reliée à la deuxième extrémité 62 du circuit 6 de liquide caloporteur par le deuxième orifice 72 de la plaque de fermeture 7. La deuxième zone de jonction 25 comporte un deuxième conduit 252 moulé dans la plaque support 2, débouchant d'une part sur la sortie 22 de liquide caloporteur et d'autre part sur un deuxième espace délimité par une deuxième nervure 254 (visible figure 7) de la plaque support 2, agencée sur la face inférieure de la plaque support 2. Une deuxième plaque de fermeture, non représentée, ferme de manière étanche ce deuxième espace en étant fixée sur la deuxième nervure 254, par exemple par brasage ou par soudage par friction malaxage. Dans ce cas la deuxième plaque de fermeture est métallique. Cette deuxième nervure 254 s'étend sous la troisième zone de réception 29 et délimite donc une troisième surface de refroidissement s3, destinée à refroidir les troisièmes composants d'électronique de puissance.

La troisième surface de refroidissement s3, optionnelle, s'étend par exemple sur au moins 10% de la troisième zone de réception 29, voire sur au moins 40 à 80% de la troisième zone de réception 29.

Les première et deuxième plaques de fermeture sont en variante réalisées en matière polymère synthétique, et par exemple collées de manière étanche sur les nervures 244, 254. Un tel choix de matière permet d'alléger le véhicule et donc de diminuer l'empreinte environnementale de celui-ci.

Dans ce mode de réalisation de l'invention, le deuxième espace s'étend également sous la première zone de réception 23. En variante, la première zone de réception 23 étant déjà refroidie par le liquide caloporteur circulant dans la base 45 de la structure 4, le deuxième espace ne s'étend que sous la troisième zone de réception 29, en passant par exemple entre l'ensemble 3 des parois latérales 32, 34, 36, 38 du module de refroidissement 1 et un bord de la plaque support 2, pour relier le deuxième orifice 27 à cette troisième zone de réception 29.

Bien sûr, l'invention n'est pas limitée aux exemples qui viennent d'être décrits et de nombreux aménagements peuvent être apportés à ces exemples sans sortir du cadre de l'invention. Notamment les caractéristiques de différentes variantes de réalisation de l'invention peuvent être combinées pour réaliser l'invention, dans la mesure où ces variantes ne sont pas incompatibles entre elles.

## Revendications

1. Module de refroidissement (1) pour composants d'électronique de puissance, comportant :
- une plaque support (2),
- des parois latérales (32, 34, 36) aptes à entourer au moins en partie des composants d'électronique de puissance, les parois latérales (32, 34, 36) délimitant une zone de réception (23) des composants d'électronique de puissance sur la plaque support (2),
- un circuit (6) de liquide caloporteur s'étendant dans les parois latérales (32, 34, 36), depuis une première extrémité (61) du circuit (6) de liquide caloporteur jusqu'à une deuxième extrémité (62) du circuit (6) de liquide caloporteur,
le module de refroidissement (1) étant **caractérisé en ce que** les parois latérales (32, 34, 36) sont formées d'une enveloppe étanche (5) et d'une structure (4) emboîtée dans l'enveloppe étanche (5), le circuit (6) de liquide caloporteur étant délimité en partie par la structure (4) et en partie par l'enveloppe étanche (5).

2. Module de refroidissement (1) selon la revendication 1, dans lequel l'enveloppe étanche (5) et la structure (4) prolongent le circuit (6) de liquide caloporteur sur la zone de réception (23).

3. Module de refroidissement (1) selon la revendication 2, dans lequel le circuit (6) de liquide caloporteur sur la zone de réception (23) forme une surface de refroidissement destinée à être interposée entre la plaque support (2) et les composants d'électronique de puissance.

4. Module de refroidissement (1) selon l'une quelconque des revendications 1 à 3, dans lequel la structure (4) est formée de blocs de matière comportant des évidements droits débouchant en regard de l'enveloppe étanche (5) ou de la plaque support (2).

5. Module de refroidissement (1) selon l'une quelconque des revendications 1 à 4, dans lequel la structure (4) est formée d'une seule pièce usinée.

6. Module de refroidissement (1) selon l'une quelconque des revendications 1 à 5, dans lequel le module de refroidissement (1) comporte au moins une plaque de fermeture (7) rapportée sur l'enveloppe étanche (5) et disposée entre la plaque support (2) et la structure (4), la plaque de fermeture (7) comportant un premier orifice (71) en regard de la première extrémité (61) du circuit (6) de liquide caloporteur et un deuxième orifice (72) en regard de la deuxième extrémité (62) du circuit (6) de liquide caloporteur.

7. Module de refroidissement (1) selon l'une quelconque des revendications 1 à 6, dans lequel le circuit (6) de liquide caloporteur parcourt trois parois latérales (32, 34, 36) du module de refroidissement, dites parois latérales de refroidissement (32, 34, 36), le module de refroidissement (1) comportant en outre au moins une paroi latérale de séparation (38) entre composants d'électronique de puissance, formée uniquement par l'enveloppe étanche (5).

8. Module de refroidissement (1) selon l'une quelconque des revendications 1 à 7, dans lequel la plaque support (2) comporte une entrée (21) de liquide caloporteur et une sortie (22) de liquide caloporteur, une première zone de jonction (24) reliant l'entrée (21) de liquide caloporteur à la première extrémité (61) du circuit (6) de liquide caloporteur et une deuxième zone de jonction (25) reliant la sortie (22) de liquide caloporteur à la deuxième extrémité (62) du circuit (6) de liquide caloporteur.

9. Module de refroidissement (1) selon la revendication 8, dans lequel les composants d'électronique de puissance sont des premiers composants d'électronique de puissance, la zone de réception (23) est une première zone de réception (23), la plaque support (2) comportant une deuxième zone de réception (28) de deuxièmes composants d'électronique de puissance s'étendant au-delà des parois latérales (32, 34, 36) et de la première zone de réception (23) , la première zone de jonction (24) ou la deuxième zone de jonction (25) étant apte à former une surface de refroidissement (s2) des deuxièmes composants d'électronique de puissance en amenant le liquide caloporteur au contact de la deuxième zone de réception (28) des deuxièmes composants d'électronique de puissance.

10. Module de refroidissement (1) selon la revendication 9, dans lequel la première zone de jonction (24) est apte à former la surface de refroidissement (s2) des deuxièmes composants d'électronique de puissance, et dans lequel la plaque support (2) comporte une troisième zone de réception (29) de troisièmes composants d'électronique de puissance s'étendant au-delà des parois latérales (32, 34, 36) et de la première zone de réception (23), la deuxième zone de jonction (25) étant apte à former une surface de refroidissement (s3) des troisièmes composants d'électronique de puissance en amenant le liquide caloporteur au contact de la troisième zone de réception (29) des troisièmes composants d'électronique de puissance.
